(19) Europäisches Patentamt
European Patent Office
Office européen des brevets

(11) **EP 3 972 746 B1**

(12) **EUROPÄISCHE PATENTSCHRIFT**

(45) Veröffentlichungstag und Bekanntmachung des Hinweises auf die Patenterteilung:
**17.04.2024 Patentblatt 2024/16**

(21) Anmeldenummer: **20705655.7**

(22) Anmeldetag: **12.02.2020**

(51) Internationale Patentklassifikation (IPC):
**B06B 1/02** (2006.01)    **B06B 1/06** (2006.01)

(52) Gemeinsame Patentklassifikation (CPC):
**B06B 1/0292; B06B 1/0644**

(86) Internationale Anmeldenummer:
**PCT/EP2020/053653**

(87) Internationale Veröffentlichungsnummer:
**WO 2020/233842 (26.11.2020 Gazette 2020/48)**

(54) **SENSOREN UND VERFAHREN ZUM ERZEUGEN VON RÄUMLICH KODIERTEN SCHALLFELDERN DURCH SCHALL-EMITTIERENDE APERTUREN MIT RÄUMLICH VARIIERENDER FREQUENZ UND BANDBREITE**

SENSORS AND METHOD FOR GENERATING SPATIALLY CODED SOUND FIELDS THROUGH SOUND-EMITTING APERTURES HAVING A SPATIALLY VARYING FREQUENCY AND BANDWIDTH

CAPTEURS ET PROCÉDÉ POUR GÉNÉRER DES CHAMPS SONORES CODÉS SPATIALEMENT AU MOYEN D'OUVERTURES ÉMETTANT UN BRUIT PRÉSENTANT UNE FRÉQUENCE ET UNE BANDE PASSANTE VARIANT SPATIALEMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.05.2019 EP 19176306**

(43) Veröffentlichungstag der Anmeldung:
**30.03.2022 Patentblatt 2022/13**

(73) Patentinhaber: **Fraunhofer-Gesellschaft zur Förderung der angewandten Forschung e.V.**
**80686 München (DE)**

(72) Erfinder:
• **TRETBAR, Steffen**
**80686 München (DE)**
• **FOURNELLE, Marc**
**80686 München (DE)**

• **SCHMITT, Daniel**
**80686 München (DE)**

(74) Vertreter: **DehnsGermany Partnerschaft von Patentanwälten**
**Theresienstraße 6-8**
**80333 München (DE)**

(56) Entgegenhaltungen:
**US-A- 5 870 351         US-A1- 2009 020 001**
**US-A1- 2017 217 794**

• **PIETER KRUIZINGA ET AL: "Compressive 3D ultrasound imaging using a single sensor", SCIENCE ADVANCES, Bd. 3, Nr. 12, 1. Dezember 2017 (2017-12-01), Seite e1701423, XP055594656, DOI: 10.1126/sciadv.1701423**

EP 3 972 746 B1

**Beschreibung**

Die vorliegende Erfindung betrifft eine Vorrichtung zum Erfassen einer dreidimensionalen Struktur durch ein Ultraschallsignal und ein Verfahren zur Bildgebung mittels eines räumlich strukturierten Schallfelds.

Stand der Technik

Ultraschall ist heute in vielen technischen Bereich von grundlegender Bedeutung, unter anderem als Methode zur Bildgebung, als Sensor in den verschiedensten Anwendungsgebieten (z.B. zum Messen von Flussgeschwindigkeiten, Entfernungen) oder zum gezielten Einbringen von Energie in ein Material bzw. Gewebe über die Ultraschallenergie.

Zur Erzeugung und Detektion von Schall, insbesondere Ultraschall, werden Schallwandler eingesetzt, die üblicherweise ausgehend von einem elektrischen Signal (Spannung oder Strom) ein akustisches Signal in der Form eines Schalldrucks ausgeben bzw. umgekehrt ausgehend von einem akustischen Signal, welches über den Schallwandler empfangen wird, ein elektrisches Signal generieren. Dazu können beispielsweise Piezoelemente verwendet werden. Jeder Schallwandler erzeugt in Abhängigkeit von seiner Geometrie (z.B. Durchmesser, Materialdicke) und/oder seiner Strukturierung oder weiteren Materialparametern ein definiertes Schallfeld mit einem natürlichen Fokus, einer bestimmten Frequenz und einer bestimmten Bandbreite.

Einfache, aus einem Element bestehende Schallwandler besitzen in der Regel kontinuierlich variierende Schallfelder mit hoher Symmetrie. Lediglich im Nahfeld ergibt sich eine starke örtliche Variation des Schalldrucks. Im Fernfeld nimmt der Schalldruck in der Regel mit zunehmendem Abstand monoton ab. Ausnahmen bilden die sogenannten Nebenkeulen, die entsprechend dem Verhältnis zwischen Aperturgröße und Wellenlänge unter bestimmten Winkeln beugungsbedingt lokale Maxima im Schallfeld erzeugen. Mit einem einelementigen Sensor kann dann eine objekt- oder medienabhängige Veränderung im Schallfeld zunächst eindimensional, im Wesentlichen entlang des Schallstrahls bzw. der gebildeten Hauptkeule erfasst werden.

Falls die Erzeugung strukturierter Schallfelder erwünscht ist, werden dann beispielsweise Linsen oder gekrümmte Aperturen verwendet, die dann den Schall in einem festen Punkt konzentrieren können. Die Varianz oder Diversität des Schallfeldes unterscheidet sich in diesem Punkt jedoch nicht wesentlich von dem ohne Linse oder Fokussierung.

Eine weitergehende Strukturierung des Schallfeldes ist durch die sogenannte Array-Technik möglich. Diese Arrays bestehen üblicherweise aus periodisch angeordneten, einzeln angesteuerten Wandler-Elementen. Diese sollten möglichst identisch sein und mit derselben Frequenz abstrahlen, um eine Komposition bzw. Dekomposition des Schallfeldes aus den Feldern der einzelnen Elemente zu ermöglichen. Durch eine zeit- oder phasenverzögerte Ansteuerung dieser Elemente gegeneinander kann das Schallfeld beispielsweise auf einen Punkt fokussiert oder um einen Winkel geschwenkt werden. Auf diese Weise kann auf elektronischem Weg eine Fokussierung des Schallfelds erreicht werden. Die individuellen Verzögerungen werden dabei basierend auf geometrischen Modellen berechnet. Durch eine zeitliche Variation der Ansteuerung kann ein Schallfeld dynamisch verändert werden. Allerdings sind für gute Auflösungen große Arrays und damit ein hoher technischer Aufwand erforderlich, insbesondere durch die große Anzahl der benötigten Kanäle und Verbindungen zur Ansteuerung bzw. Signalerfassung.

Ebenso können Arrays auch verwendet werden, um die erfassten Signale räumlich zuzuordnen, also Informationen über eine Fläche oder ein Volumen z.B. zur dreidimensionalen Bildgebung, dreidimensionalen Oberflächenerfassung, dreidimensionalen Abstandserfassung oder Material-/Gewebecharakterisierung zu gewinnen. Jedoch bleibt auch hier der Nachteil, dass mit zunehmender Auflösung Herstellungskosten und Komplexität der Arrays sehr hoch liegen, da für jeden Sensor, d.h. jedes Element des Arrays wieder ein eigener Sende-Empfangs-Kanal erforderlich ist. Außerdem ist trotz fortgeschrittener Integrationsdichte der Platzbedarf sehr hoch. Darüber hinaus können zur Erzeugung strukturierter Schallfelder sogenannte akustische Hologramme oder Phasenplatten verwendet werden, bei denen eine komplexe zeitliche Verzögerung bzw. Phasenverschiebung von örtlich aufgelösten Ultraschallwellen topologisch kodiert sind. Auf diese Weise können beispielsweise strukturierte Ultraschallfelder in Fluiden gebildet werden. Allerdings sind sie für Luftschall bzw. niedrige Frequenzbereiche nicht geeignet, und Dämpfungen und Mehrfachreflexionen können Probleme aufwerfen.

Aus dem Dokument "Comprehensive 3D Ultrasound imaging using a single sensor, Kruizinga et al., Science Advances, 2017, ist ein Verfahren zur Bildgebung durch ein räumliches Schallfeld auf Basis einer Phasencodierung bekannt

Die US 2017/0217794 A1 offenbart einen sogenannten Dickenschwinger, also ein Piezoelement mit Bereichen unterschiedlicher Dicke.

Die US 5870351 A offenbart einen Ultraschallwandler mit mehreren Aperturen, die durch Membranen unterschiedlicher Größe und Form gebildet sein können. Diese Aperturen werden jeweils einzeln angesteuert

Offenbarung der Erfindung

Die vorliegende Erfindung schlägt vor eine Vorrichtung zum Erfassen einer dreidimensionalen Struktur durch ein Ultraschallsignal mit den Merkmalen des Patentanspruchs 1 sowie ein Verfahren zur Bildgebung mittels eine räumlich strukturierten Schallfelds mit den Merkmalen des Patentanspruchs 11. Vorteilhafte Ausgestaltungen sind Gegenstand der Unteransprüche.

Zur weiteren Erläuterung werden ferner ein Schallwandler, ein Herstellungsverfahren für einen Schallwandler sowie ein Detektionsverfahren unter Verwendung eines derartigen Schallwandlers beschrieben.

Insbesondere wird ein Schallwandler zum Erzeugen und/oder Empfangen eines räumlich strukturierten Schallfelds beschrieben, welcher eine Gesamtapertur umfasst, welche das Schallfeld erzeugt und/oder empfängt, wobei die Gesamtapertur mehrere Subaperturen umfasst, wobei jede der Subaperturen zum Empfangen und/oder Erzeugen von Ultraschall mit einem spezifischen Frequenzspektrum eingerichtet ist, wobei sich die spezifischen Frequenzspektren von mindestens zwei der Subaperturen unterscheiden, und wobei alle Subaperturen der Gesamtapertur mit demselben elektronischen Ansteuerungskanal verbunden sind. Durch den einzelnen, gemeinsamen elektronischen Ansteuerungskanal sind Schallwandler auf sehr kleinem Bauraum und mit geringen Kosten realisierbar, ohne dabei auf räumliche Informationen des Schallfelds verzichten zu müssen. Die Verwendung von nur einem elektrischen Sende-Empfangs-Kanal für einen Ultraschallsensor kann die Kosten um einen Faktor 100 bis 1000 senken und dabei gleichzeitig die Messdimension um einen Faktor 3 erhöhen. Außerdem sind derartige Sensoren verschiedener Typen für alle Schallbereiche anwendbar, beispielsweise als Luftschall, Körperschall, in Wasser, in Gewebe und weiteren.

Dabei können die mehreren Subaperturen im Wesentlichen in einer Ebene senkrecht zur Ausbreitungsrichtung des Schallfelds verteilt angeordnet sein. Die verteilte Anordnung von Subaperturen unterschiedlicher Frequenzspektren über die Gesamtapertur hinweg ergibt eine Codierung räumlicher Informationen in das Signal über die Frequenz. Der Begriff "Ebene" kann dabei auch einen vorgegebenen lateralen Abschnitt entlang der Ausbreitungsrichtung umfassen, wenn beispielsweise Subaperturen unterschiedlicher Höhe oder Dicke eingesetzt werden oder wenn die Apertur als ganzes beispielsweise eine Krümmung aufweist, es sich also um eine gekrümmte Ebene handelt.

Eine Möglichkeit zur Erzeugung unterschiedlicher Frequenzspektren mittels der Subaperturen besteht darin, Subaperturen mit zumindest teilweise unterschiedlichen Durchmessern vorzusehen. In vielen Ausführungsformen bestimmt der Durchmesser einer Apertur, z.B. der Durchmesser einer piezoelektrisch oder kapazitiv angetriebenen Membran, die erzeugte Schallfrequenz zumindest teilweise.

Bevorzugt kann der elektrische Ansteuerungskanal zum Ausgeben eines Wechselsignals (z.B. ein Wechselstromsignal oder Wechselspannungssignal) mit einem vorgegebenen Frequenzspektrum, beispielsweise ein kurzer Puls mit hoher Bandbreite, an die Subaperturen eingerichtet sein, wobei das Wechselsignal zumindest ein bewegliches bzw. schwingfähiges Element jeder Subapertur zu Schwingungen anregt. Als bewegliches Element kommen je nach technischer Ausführung die unterschiedlichsten Einrichtungen in Frage; während das an die Subaperturen gegebene Wechselsignal damit für jede Subapertur zunächst gleich ist, können durch Unterschiede in der Auslegung und Dimensionierung der Subaperturen dennoch mehrere verschiedene Frequenzspektren erzeugt werden.

In einer möglichen Ausführungsform kann die Gesamtapertur durch ein Piezoelement gebildet werden, beispielsweise eine Piezokeramik oder ein Piezo-Composit-Material, wobei die Subaperturen durch Bereiche unterschiedlicher Dicke des Piezoelements gebildet werden, welche zusätzlich auch ganz oder teilweise durch Einschneiden voneinander getrennt werden können. In diesem Fall kann das Piezoelement bevorzugt in der Dickenmode betrieben werden. Auf diese Weise erhält man ein einstückiges Element mit Bereichen unterschiedlicher erzeugter Frequenzen, das einfach herzustellen und in andere Bauteile integrierbar ist.

Gemäß einer weiteren Ausführungsform kann die Gesamtapertur als piezoelektrischer oder kapazitiver mikromechanischer Schallwandler ausgebildet sein, wobei die mehreren Subaperturen als mehrere Kavitäten oder über den Kavitäten angeordnete Membranen des Schallwandlers ausgebildet sind, und wobei die Membranen zumindest teilweise unterschiedliche Durchmesser aufweisen. Diese mikrosystemtechnischen Elemente erlauben eine besonders kleine Bauform und eine einfache integrierte Fertigung mit anderen Elementen und können daher für eine Vielzahl von Sensoren eingesetzt werden.

In einer alternativen Ausführungsform kann eine Gesamtapertur aus einem Einzelschallwandler mit hoher Bandbreite zusammen mit einem passiven Vorsatzmodul für den Einzelschallwandler gebildet werden, wobei das passive Vorsatzmodul Bereiche unterschiedlicher frequenzabhängiger Dämpfung umfasst, welche die mehreren Subaperturen bilden. Die unterschiedlichen Frequenzspektren der Subaperturen werden also durch lokale Modulation des Einzelschallwandlers erzeugt, wobei die Bereiche zumindest teilweise unterschiedliche frequenzabhängige Dämpfungskurven aufweisen können.

Eine weitere Möglichkeit besteht darin, die Subaperturen durch Einzelschallwandler mit hoher Bandbreite zu bilden, wobei jedem der Einzelschallwandler ein elektronischer Filter vorgeschaltet ist, welcher die Bandbreite des Einzelschallwandlers auf ein spezifisches Frequenzspektrum beschränkt. In dieser Variante können beispielsweise besonders einfach identische Einzelschallwandler verwendet werden, die ähnlich einem Array angeordnet werden, aber alle gemeinsam über den einen elektronischen Ansteuerungskanal kontaktiert sind. Die verschiedenen Frequenzen und damit die räumliche Frequenzcodierung ergeben sich durch die Filterung.

Eine weitere Ausführungsform sieht vor, dass die Gesamtapertur durch einen passiven Grundkörper mit Ausnehmungen für mehrere Einzelschallwandler gebildet sein kann, wobei die mehreren Einzelschallwandler die mehreren Subaperturen bilden. Bei einer modularen Fertigung kann hier eine Vielzahl von Schallfeldern aus einem vorgefertigten Set von passenden Einzelschallwandlern in passenden Einsätzen des Grundkörpers gebildet werden, indem die jeweils genutzten Elemente flexibel angepasst oder ausgetauscht werden.

Darüber hinaus kann aus jedem der zuvor beschriebenen Schallwandler auch eine Wandlervorrichtung gebildet werden, die mehrere periodisch angeordnete Schallwandler nach einem der vorhergehenden Ansprüche, wobei jeder Schallwandler einen separaten elektronischen Ansteuerungskanal aufweist und mit diesem verbunden ist. Auf diese Weise wird erneut ein Array gebildet, welches aber im Vergleich zu üblichen Schallwandler-Arrays einen um mehrere Dimensionen geringeren Aufwand insbesondere für die Ansteuerungs- bzw. Detektionskanäle benötigt.

Es wird außerdem ein Verfahren zur Herstellung eines Schallwandlers wie zuvor genannt beschrieben, bei dem zunächst eine gewünschte räumliche Schallfeldverteilung einer Gesamtapertur vorgegeben wird, und dann aus der erwünschten Schallfeldverteilung Parameter mehrerer Subaperturen gewonnen werden können, welche die Gesamtapertur bilden, wobei das Gewinnen der Parameter beispielsweise auf einer analytischen Berechnung der Parameter, einer numerische Berechnung der Parameter, oder einem Simulationsverfahren für die Parameter beruhen kann. So kann ein gezielt strukturiertes Schallfeld gebildet werden, das beispielsweise einen definierten Fokus oder andere räumliche Verteilungen bildet, wie sie für viele Zwecke wie Bildgebung oder Materialbearbeitung erforderlich sind. Alternativ kann auch eine randomisierte Schallfeldverteilung für bestimmte Zwecke genutzt werden.

Insbesondere können dabei zum Gewinnen der Parameter der Subaperturen zunächst Teil-Schallfeldverteilungen mit spezifischem Frequenzspektrum berechnet werden, so, dass eine Überlagerung aller Teil-Schallfeldverteilungen die gewünschte räumliche Schallfeldverteilung ergibt, und dann die geeigneten Parameter der Subaperturen für jede dieser erhaltenen Teil-Schallfeldverteilungen bestimmt bzw. berechnet werden. Als zu bestimmende Parameter der Subaperturen können dabei beispielsweise die folgenden einzeln oder in beliebiger geeigneter Kombination genutzt werden: Abmessungen einer Subapertur, geometrische Form einer Subapertur, Dicke eines beweglichen Elements einer Subapertur, relative Anordnung einer Subapertur innerhalb der Gesamtapertur. Es ist auch möglich, dass bestimmte Parameter der Subaperturen festgeschrieben sind und nicht verändert werden, beispielsweise aufgrund von Materialeigenschaften oder Vorgaben zur Herstellung eines bestimmten Schallwandlers, während andere wie die Form dann in bestimmten Grenzen oder beliebig angepasst werden können, bis die gewünschte Schallfeldverteilung erreicht ist. In anderen Ausführungsformen dagegen könnten sämtliche Parameter einer Subapertur frei variiert werden, wenn etwa eine Apertur völlig neu entworfen wird und die optimale Bauform für ein erwünschtes Schallfeld gefunden werden soll.

Darüber hinaus wird ein Verfahren zur Dekodierung eines räumlich strukturierten Schallfelds unter Verwendung eines wie oben beschriebenen frequenzcodierten Schallwandlers beschrieben, welches die folgenden Schritte umfasst: Es wird zunächst ein Ultraschallsignal unter Verwendung des Schallwandlers detektiert, welches reflektierte Signale eines eingestrahlten Schallfelds umfasst, wobei das eingestrahlte Schallfeld eine vorbestimmte räumliche Struktur aufweist und optional auch vom zum Empfang eingesetzten Wandler erzeugt werden kann (Puls-Echo-Betrieb), und dann wird auf Grundlage des erfassten Signals und der vorbestimmten räumlichen Struktur des eingestrahlten Schallfelds die räumliche Verteilung von reflektierenden Elementen berechnet, welche die reflektierten Signale erzeugen. Dabei liegt das detektierte Ultraschallsignal bevorzugt als Ausgangssignal des einen elektrischen Ansteuerungskanals des Schallwandlers vor und kann dann entsprechend weiterverarbeitet werden.

Beispielsweise kann aus der so berechneten räumlichen Verteilung von Reflektoren bzw. reflektierenden Elementen dann ein zwei- oder dreidimensionales Bild aufgebaut und dargestellt werden.

Die beschriebenen frequenzcodierten Schallwandler sind in vielen speziellen Einsatzgebieten von großem Vorteil. Da beispielsweise nur noch ein Signal angesteuert bzw. empfangen werden muss und die resultierenden Datenmengen deutlich geringer sind als im Stand der Technik, bieten sich derartige Lösungen besonders auch für eine Anbindung über Funkschnittstellen an. Ebenso sinkt der Stromverbrauch und die Nutzlast bzw. Baugröße, so dass beispielsweise Systeme in Kathetern in der Medizintechnik optimal gestaltet werden können. Auch im Bereich Sonar bieten sich große Vorteile. Die beschriebenen Schallwandler sind sowohl in ihrer Größe als auch in ihren Frequenzbereichen ohne Verlust ihrer Vorteile und Eigenschaften leicht skalierbar und damit für die verschiedensten Anwendungen einsetzbar.

Weitere Vorteile und Ausgestaltungen der Erfindung ergeben sich aus der Beschreibung und der beiliegenden Zeichnung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand von Ausführungsbeispielen in der Zeichnung schematisch dargestellt und wird im Folgenden unter Bezugnahme auf die Zeichnung beschrieben.

Figurenbeschreibung

Figur 1 zeigt schematisch eine Gesamtapertur eines Schallwandlers, die mehrere Subaperturen unterschiedlicher Größe umfasst, gemäß einer Ausführungsform;

Figuren 2a bis 2c zeigen Schallwandler-Varianten mit verschieden ausgeformten Subaperturen und Gesamtaperturen;

Figur 3a zeigt eine höhenstrukturierte Piezokeramik als Schallwandler gemäß einer Ausführungsform;

Figur 3b zeigt als Explosionsansicht die Piezokeramik aus Figur 3a mit kontaktierenden Elektroden,

Figur 3c zeigt zwei Varianten der Schallabstrahlung für einen Schallwandler gemäß Figur 3 a,

Figur 3d zeigt einen möglichen Einbau eines Schallwandlers nach Figur 3a in ein Gehäuse;

Figur 4 zeigt eine weitere Ausführungsform, bei der Subaperturen mit unterschiedlichem Frequenzspektrum durch elektronische Filter gebildet sind;

Figuren 5a und 5b zeigen eine weitere Ausführungsform, bei der Subaperturen mit unterschiedlichem Frequenzspektrum durch einen Schallwandler mit einem passiven Vorsatzmodul gebildet werden;

Figur 6 zeigt eine Ausführungsform, bei der Ultraschall durch photoakustische Anregung an einer Membran erzeugt wird;

Figur 7 zeigt ein Array aus mehreren beispielhaften Schallwandlern gemäß der Erfindung;

Figur 8 stellt schematisch die Verfahrensschritte zum Detektieren von Ultraschall mit einem beispielhaften Schallwandler dar, und

Figur 9 stellt schematisch die Verfahrensschritte eines Herstellungsverfahrens für einen beispielhaften Schallwandler dar.

Ausführliche Beschreibung beispielhafter Ausführungsformen

Im folgenden werden einige beispielhafte Ausführungsformen beschrieben, bei denen auf unterschiedliche Art und Weise eine Frequenzcodierung eines Schallfelds erreicht wird, indem das Feld in einer Ebene senkrecht zur Ausbreitungsrichtung, also in lateraler Ausdehnung, aus Teil-Schallfeldern spezifischer Frequenzspektren zusammengesetzt wird, welche durch Überlagerung dann das frequenzcodierte Schallfeld der Gesamtapertur bilden. Durch die Kombination unterschiedlicher Frequenzen bzw. Frequenzspektren mit der Ortsinformation, die durch den Entstehungsort der jeweiligen Frequenz in das überlagerte Gesamtschallfeld eingebracht wird, erhält man ein räumlich strukturiertes, frequenzcodiertes Schallfeld.

Dabei wird die Gesamtapertur nur durch einen einzigen Sende-/Empfangskanal angesteuert, also auch nur mit einem Eingangssignal z.B. in Form einer Wechselspannung. Die unterschiedlichen Frequenzspektren, aus denen das überlagerte Gesamtsignal gebildet wird, werden dabei bevorzugt durch lokal unterschiedliche Eigenschaften des Schallwandlers erzeugt Ebenso kann umgekehrt ein einzelnes frequenzcodiertes Detektionssignal durch geeignete Rekonstruktionsalgorithmen räumliche Informationen liefern.

Das Grundprinzip der Erfindung kann im Wesentlichen mit jeder Technik der Ultraschallerzeugung verwendet werden, solange es möglich ist, abhängig von Eigenschaften einer Apertur lokal unterschiedliche Schallfrequenzen zu erzeugen. Dabei ist Ultraschall als ein Frequenzbereich von Schallfrequenzen zu verstehen, der oberhalb des hörbaren Schallspektrums, also etwa oberhalb von 20kHz beginnt und bis in den GHz-Bereich reicht Medizinische Anwendungen liegen beispielsweise häufig im Bereich von MHz. Generell können aber bei der Anwendung von Ultraschall auch hörbare Frequenzanteile vorliegen; die Erzeugung der Schallwellen und auch die hier beschriebenen Überlagerungen zur räumlichen Frequenzcodierung unterscheiden sich nach ihrem Prinzip nicht.

Generell sind Schallwandler sowohl als Sender als auch als Empfänger einsetzbar; dabei sorgt ein angelegtes Signal, z.B. ein Wechselstromsignal an der jeweiligen Struktur dafür, dass ein entsprechendes Element zum Schwingen angeregt wird und so die Ultraschallwellen erzeugt, während umgekehrt bei Auftreffen einer Ultraschallwelle auf das Element und dadurch ausgelöste Schwingungen des Elements ein elektrisches Signal generiert wird, das wieder ausgelesen und weiter verarbeitet werden kann. Es versteht sich daher, dass alle im Folgenden aufgeführten Beispiele für einen Ultraschallsender ebenso auf einen Ultraschallempfänger übertragen werden können und umgekehrt, auch wenn das jeweilige Beispiel nur konkret für die Schallerzeugung oder den Schall empfang beschrieben sein mag.

Eine Möglichkeit zur Erzeugung eines räumlich frequenzkodierten Schallfeldes aus einem einzigen Ansteuerungssignal oder zur Dekodierung eines dreidimensionalen Schallfelds aus einem einzelnen eingehenden Signal beruht darauf, eine Apertur mit Unterstrukturen bzw. Subaperturen zu versehen, die jeweils spezifische Frequenzspektren und/oder Bandbreiten aufweisen. Das Schallfeld wird dann additiv oder subtraktiv aus den einzelnen Frequenzspektren aller Subaperturen gebildet. Dabei können die Frequenzen der Subaperturen prinzipiell auch zumindest teilweise gleich sein, können sich aber auch von Subapertur zu Subapertur jeweils unterscheiden.

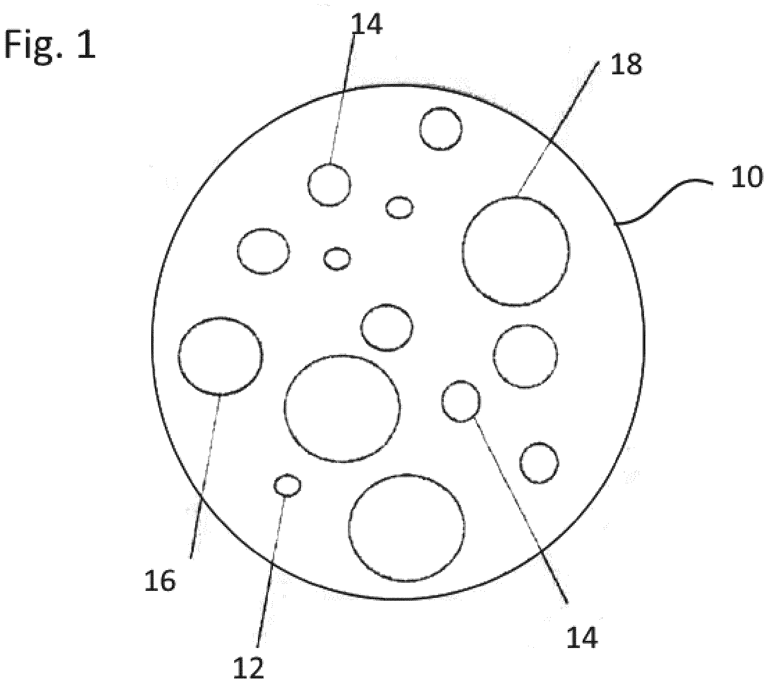

Figur 1 zeigt eine schematische Darstellung eines derartigen Schallwandlers, der eine Gesamtapertur 10 aufweist, die mehrere Subaperturen 12, 14, 16, 18 unterschiedlicher Größe umfasst. Bevorzugt sind die Subaperturen ansonsten so ausgelegt, dass die unterschiedlichen Größen bzw. Durchmesser zu jeweils unterschiedlichen erzeugten Frequenzen führen. Es können auch mehrere Subaperturen gleich ausgestaltet sein oder beispielsweise eine bestimmte Anzahl von Grundtypen für die Subaperturen vorgegeben sein, die dann beliebig zu einer Gesamtapertur kombiniert werden. Beispielsweise können zwei oder mehr Subaperturen 14 den gleichen Durchmesser und die gleiche spezifische Frequenz aufweisen, während andere Subaperturen 12, 16, 18 größer oder kleiner dimensioniert sind. Es können auch weitere Parameter der Subaperturen verändert sein, etwa Dicke oder Beweglichkeit einer Membran, so dass auch bei gleichen Durchmessern möglicherweise unterschiedliche Frequenzen erzeugt werden können. Alle Subaperturen zusammen bilden über ihre Gesamtfläche hinweg die Gesamtapertur 10. Dabei kann dieses dargestellte Grundprinzip auf verschiedene Ausführungsformen angewendet werden.

Als eine beispielhafte Ausführungsform für einen Wandler 10 wie in Figur 1 bieten sich MEMS (microelectromechanical systems)-Sensoren an, also mikrosystemtechnisch hergestellte Schallwandler auf Basis schwingender Membranen, zum Beispiel als piezoelektrische Wandler (PMUT, piezoelectric micromachined ultrasonic transducer) oder als kapazitive Wandler (CMUT, capacitive micromachined ultrasonic transducer).

CMUT-Schallwandler sind Ultraschallwandler, deren Schallerzeugung auf einer elektrostatisch verursachten Auslenkung und einer damit einhergehenden Abstandsänderung beruht Ein CMUT-Schwallwandler kann eine Kavität in einem Siliziumsubstrat aufweisen, das als erste Elektrode dient und von einer dünnen, metallisierten Membran bedeckt sein kann, die als zweite bewegliche Elektrode dient. Wird ein Wechselstromsignal an den beiden Elektroden angelegt, wird die Membran zum Schwingen angeregt und Ultraschallwellen werden generiert, so dass der CMUT-Schallwandler als Sender arbeitet Bei einem Schwingen der Membran durch auftreffende Ultraschallwellen ändert sich dagegen die Kapazität des CMUT-Schallwandlers, ein alternierendes Signal wird generiert und der CMUT-Schallwandler arbeitet als Messeinheit. Abwandlungen bzw. Weiterentwicklungen wie etwa polymerbasierte CMUT-Elemente (polyCMUT) können ebenso eingesetzt werden.

Auf ähnliche Weise beruht ein PMUT-Schallwandler darauf, dass auf einer mikromechanisch gefertigten Kavität z.B. in einem Siliziumsubstrat eine piezoelektrische Membran mit kontaktierenden Elektroden angebracht ist, welche das Ultraschallfeld erzeugt oder aufnimmt.

Vorteile dieser mikrosystemtechnischen Elemente liegen beispielsweise darin, dass sie eine einfache Fertigung, geringe Baugröße und niedrige Kosten mit sich bringen und auch integriert gefertigt werden können.

Bei diesem Sensor- bzw. Schallwandlertyp kann nun die Diversifizierung der Frequenz beispielsweise allein durch den Membrandurchmesser bzw. den Durchmesser der Kavitäten erfolgen.

Beispielsweise könnte eine Gesamtapertur 10 eines cMUT oder pMUT wie in der Figur 1 ausgebildet sein und mehrere Membranen 12, 14, 16, 18 unterschiedlicher Durchmesser als Subaperturen aufweisen. Die verschiedenen Durchmesser sorgen dann für unterschiedliche Eigenmoden und damit unterschiedliche angeregte Ultraschallfrequenzen. Ebenso kann auch die Anordnung der mehreren Subaperturen 12, 14, 16, 18 angepasst werden, um das aus den Einzelfrequenzen bzw. einzelnen Frequenzspektren zusammengesetzte Schallfeld zu verändern.

Weiter ist auch eine Änderung der Form der Membran bzw. Kavität möglich, um z.B. bei einer schwingenden Membran mit Elektrode eines cMUT bei gleicher lateraler Dimension durch die Abhängigkeit des Eigenschwingungsspektrums von der Form (rund, quadratisch, hexagonal, etc.) unterschiedliche Frequenzen zu realisieren. Die Grundform der Gesamtapertur kann dabei belassen werden oder ebenfalls abgeändert werden, um z.B. eine bestimmte räumliche Verteilung der Membranen zu erreichen.

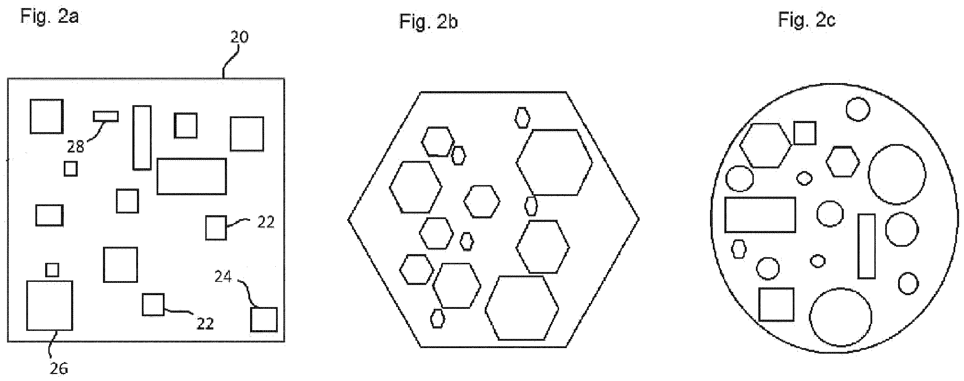

Figur 2 zeigt drei beispielhafte Ausführungsformen von zusammengesetzten Aperturen, die beispielsweise wieder als cMUT oder pMUT-Elemente ausgeführt sein können.

In Figur 2a ist eine Variante mit rechteckiger Grundform der Gesamtapertur 20 sowie mehreren, ebenfalls rechteckig ausgeformten Membranen 22, 24, 26, 28 als Subaperturen gezeigt Wie auch in der zuvor beschriebenen Ausführungsform können die Membranen unterschiedliche wie auch teilweise gleiche Durchmesser aufweisen, wobei die jeweiligen Durchmesser so gewählt werden, dass die erzeugten Frequenzen und örtlichen Verteilungen der Schwingungserzeuger das erwünschte Schallfeld ergeben. Auch die Grundform der Subaperturen kann sich mehr oder weniger stark unterscheiden; es könnten sowohl Membranen derselben Form, nur mit variierenden Durchmessern verwendet werden, als auch Membranen mit verschiedenen Rechteckformen wie gezeigt. Dabei können die Membranen symmetrisch wie Element 22, 24, und 26 oder nur teilsymmetrisch wie Element 28 gestaltet sein, was beispielsweise auch Einfluss auf die relevanten Schwingungsmoden haben kann.

Figur 2b zeigt eine sechseckige Grundform als Apertur mit mehreren sechseckigen Membranen, während Figur 2c eine runde Apertur mit Subaperturen bzw. Membranen unterschiedlicher Formen und Durchmesser zeigt, unter anderem mit kreisförmigen, rechteckigen und sechseckigen Membranen Es versteht sich, dass die Formen und Größen dabei beliebig gewählt werden können und auch andere symmetrische oder asymmetrische Formen für die Aperturen und Subaperturen denkbar sind, die eine günstige Fertigung der Membranen und Anbringung der piezoelektrischen Elemente bzw. beweglichen Elektroden ermöglichen und deren Frequenzspektren das gewünschte Schallfeld in Summe erzeugen.

Alle in den Figuren 2a bis 2c gezeigten Varianten können insbesondere mit beliebigen mikrosystemtechnisch hergestellten Schallwandlern umgesetzt werden, insbesondere den bereits beschriebenen cMUT- und pMUT-Elementen.

Zusätzlich oder alternativ zu den beschriebenen Variationen kann beispielsweise auch die Dicke der Membran oder beweglichen Platte in einem cMUT- oder pMUT-Element über die Apertur hinweg variiert werden, was durch die veränderten Schwingungseigenschaften ebenfalls zu einer Änderung der Frequenzen führt.

Die Festlegung der geeigneten Durchmesser, Formen und Anordnungen der einzelnen Subaperturen kann nach bestimmten Vorgaben gewählt werden oder beispielsweise durch entsprechende numerische und/oder analytische Berechnungen, Simulationsverfahren und Näherungen gefunden werden. Auch eine randomisierte Anordnung und Parameterwahl ist möglich.

Wie bereits allgemein beschrieben wurde, wird die gesamte Apertur mit den verschiedenen unterschiedlichen Membranen durch einen einzigen Signalkanal elektrisch kontaktiert, über den bei der Verwendung als Ultraschallsender die Elektroden/Piezoelemente mit einer Wechselspannung belegt werden können, während bei der Verwendung als Ultraschallempfänger ein einzelnes moduliertes Signal über den Signalkanal der Apertur empfangen werden kann und dann durch entsprechende Signalbearbeitung die dreidimensionale Information gewonnen werden kann.

Eine weitere mögliche Ausführungsform beruht auf Sensoren auf Basis piezoaktiver Materialien, beispielsweise Piezo-Keramiken wie Blei-Titanium-Zirkonat (PZT), piezoelektrische Komposite wie z.B. 1-3-Composite, welche üblicherweise piezokeramische Elemente kombiniert mit einem Polymer umfassen, PVDF-Folien mit Piezoeffekt, gedruckte oder abgeschiedene piezoaktive Materialien, und weitere. Auch in diesem Fall können die unterschiedlichen Frequenzen zur Kombination des erwünschten Schallfelds und damit die räumliche Kodierung des Schallfelds durch eine geeignete Strukturierung über die Gesamtapertur hinweg erreicht werden.

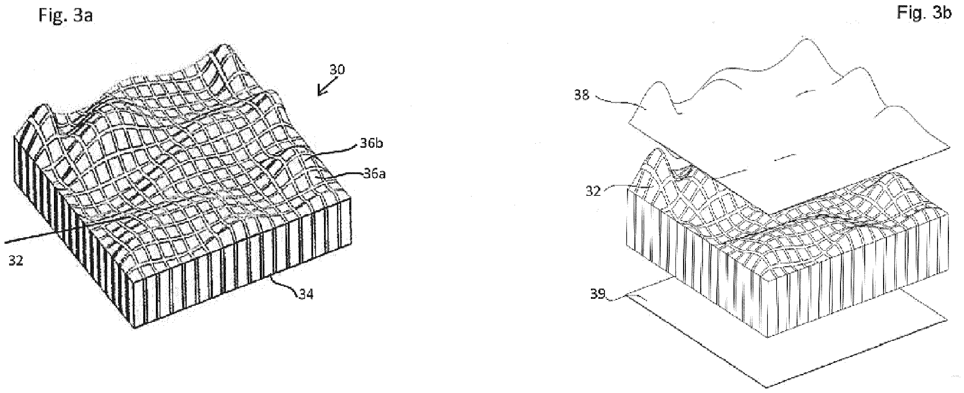

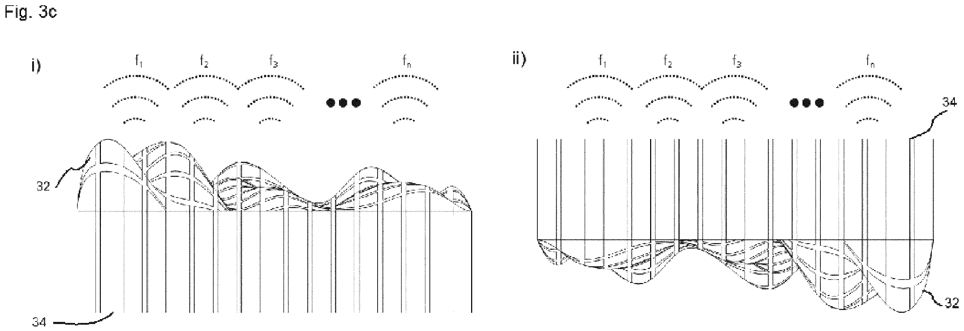

In der Regel werden auf piezoelektrischen Keramiken beruhende Wandler in der Dickenmode betrieben. Eine Frequenzkodierung kann also in diesem Fall durch variierende Höhenprofile in der Ebene der aktiven Fläche realisiert werden. Figur 3a zeigt ein Beispiel einer derartigen Gesamtapertur, die aus einer strukturierten Piezokeramik 30 unterschiedlicher Dicke gebildet ist, als schematische 3D-Ansicht. Durch die unterschiedliche Dicke 32 des Keramikmaterials emittiert das Element an verschiedenen Stellen 36a, 36b der Apertur unterschiedliche Ultraschallfrequenzen. Das resultierende Frequenzsignal der Gesamtapertur ist damit eine Überlagerung von Frequenzsignalen aus allen Unterbereichen mit unterschiedlicher Dicke.

Bereiche unterschiedlicher Dicke 36a, 36b können als einzelne Subaperturen betrachtet werden. Die Bereiche unterschiedlicher Dicke können dabei wie in der Figur kontinuierlich ineinander übergehen oder können alternativ durch eine geeignete laterale Strukturierung ganz oder teilweise voneinander getrennt ausgebildet sein, so dass separate Subaperturen entstehen.

Dabei kann wie in der Figur gezeigt eine der beiden Grundflächen 34 planar sein, während die andere Fläche 32 mit dem Höhenprofil versehen ist Figur 3b zeigt den Gesamtaufbau einer Piezokeramik wie in Figur 3a mit den kontaktierenden Elektroden 38 und 39, die auf beiden Grundflächen angeordnet sind. Ebenso ist grundsätzlich ein Aufbau möglich, bei dem beide Grundflächen strukturiert sind und keine rein planare Fläche vorliegt.

Figur 3c zeigt zwei Querschnitte durch eine derartige Piezokeramik, wobei in der ersten Alternative i) die Schallabstrahlung über die gekrümmte Fläche 32 als Apertur dargestellt ist, während in der zweiten Alternative ii) umgekehrt die planare Fläche 34 als Apertur vorgesehen ist und die Schallabstrahlung also über diese Fläche erfolgt Insbesondere die Nutzung der planaren Fläche 34 als Apertur ermöglicht einen problemlosen Einbau z.B. in geeignete Gehäuse.

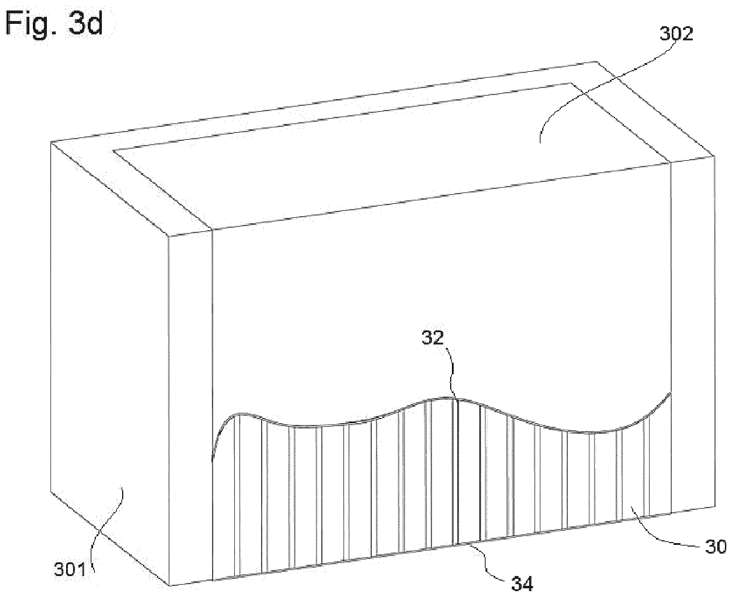

Einen derartigen Aufbau zeigt die Figur 3d, in der ein piezokeramisches Element mit Höhenprofil als Schallwandler 30 in ein Gehäuse 301 eingesetzt ist. Die seitlichen Flächen und Dimensionen des Gehäuses 301 können dabei im Wesentlichen beliebig gewählt werden und daher wie hier gezeigt einfach senkrecht abgeflacht sein. Die nach oben weisende plane Außenfläche 34 bildet hier die schallerzeugende oder schallaufnehmende Apertur des piezokeramischen Elements 30. Die höhenprofilierte Fläche 32 der Piezokeramik ist dagegen in ein geeignetes Trägermaterial 302 eingebettet bzw. vergossen und optional auch dadurch fixiert, welches auch das restliche Gehäuse ausfüllt. Das Trägermaterial 302 kann gleichzeitig als Befestigung für die Piezokeramik 30 in dem Gehäuse 301 dienen. Die elektrische Kontaktierung über den Ansteuerungskanal ist in dieser Figur nicht sichtbar, kann aber erneut wie in Fig. 3b über flächige Elektroden vorgenommen werden.

Während die vorstehenden Beispiele auf einer Gesamtstruktur mit räumlich variierenden Teilstrukturen zur Erzeugung verschiedener Schallfrequenzen beruhten, können auch Ausführungsformen gewählt werden, in denen einzelne Strukturen mit spezifischen Frequenzspektren zu einer Gesamtapertur zusammengesetzt werden.

In einer weiteren möglichen Ausführungsform zur Erzeugung und/oder Detektion eines frequenzcodierten Schallfelds ist ein neutraler Grundkörper vorgesehen, in dem mehrere Aussparungen oder Einsätze für einelementige Schallwandler vorgesehen sind, welche die Subaperturen bilden. Die Grundform kann dabei beispielsweise wie in Figur 1 oder wie in den Figuren 2 a bis c gebildet sein, so dass der Grundkörper die Gesamtapertur 10 bzw. 20 bildet, während die Aussparungen oder Einsätze den dort beschriebenen Membranen 12, 14, 16, 18 bzw. 22, 24, 26, 28 entsprechen können und entsprechend geformt sein können, beispielsweise als rechteckige Einzelschallwandler in einem beliebig gestalteten Grundkörper. Alle einelementigen Schallwandler in dem Grundkörper sind wieder elektrisch gemeinsam kontaktiert. Die Schallwandler können unterschiedliche Frequenzen und Bandbreiten aufweisen, beispielsweise durch entsprechende Wahl ihres Durchmessers oder anderer Parameter. Die Gesamtheit der konkret angeordneten Einzelschallwandler bildet dann mit dem Grundkörper die Gesamtapertur.

Zur variablen Fertigung derartiger Elemente ist es auch denkbar, aus einer Kombination eines vorgegebenen Grundkörpers mit einer Anzahl von N Aussparungen bzw. Einsätzen für Schallwandler sowie N Schallwandlern, die in diese Aussparungen eingesetzt werden können, eine jeweils an die Anwendungsbedingungen angepasste geeignete Variante zu finden. Damit können in Kombination N! verschiedene Schallfeldvarianten gefunden werden und entsprechend angepasst werden. Ebenso könnten für Einsätze mit vorgesehenem Durchmesser auch unterschiedliche einsetzbare Schallwandler genutzt werden, beispielsweise mit verschiedenen Membranen und Anregungseigenschaften. Eine ideale Zuordnung von N Wandlern zu N Positionen bzw. Einsätzen im Grundkörper kann dabei über ein numerisches Lösungsverfahren identifiziert werden.

Weitere Ausführungsbeispiele beruhen auf der lokalen Modulation der Frequenzen von Unterstrukturen auf Basis einer Grundstruktur mit hoher Bandbreite.

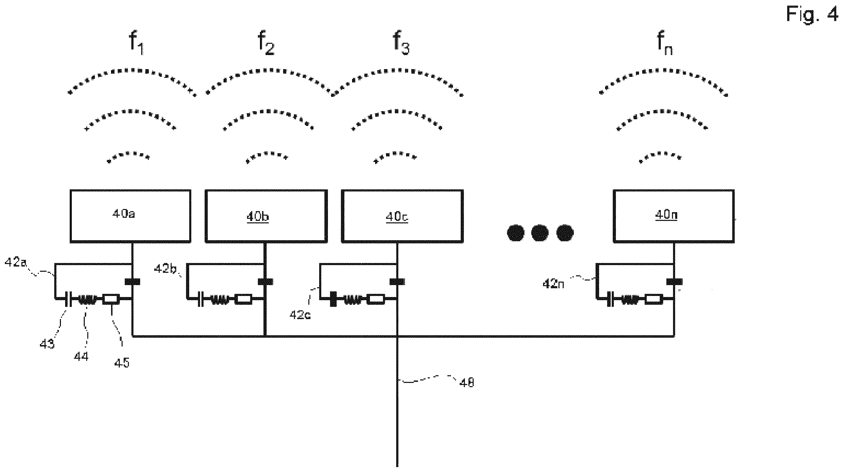

Figur 4 zeigt ein derartiges Beispiel, bei dem einzelne Subaperturen in der Form von einzelnen Schallwandlern 40a, 40b, 40c, ..., 40n eingesetzt werden, die erneut alle über einen gemeinsamen elektrischen Kanal 48 angesteuert werden, aber dann mit unterschiedlichen spektralen Filtern 42a, 42b, 42c, ... 42n zur lokalen Änderung der Frequenzen versehen sind. Dabei können die einzelnen Subaperturen 40a, 40b, 40c, ... 40n auch ähnlich zueinander oder gar identisch sein, so dass sich eine besonders einfache Fertigung ergibt. Bevorzugt sollen die Subaperturen eine sehr hohe Bandbreite aufweisen, um eine ausreichende Variation der Frequenzen durch Filterung zu ermöglichen. Die spektralen Filter 42a, 42b, 42c, 42n können durch entsprechende elektrische Schaltungen realisiert werden. Auf diese Weise können den einzelnen Subaperturen spezifische Frequenzen und Bandbreiten zugeordnet werden. Als Filter können beispielsweise übliche RLC-Glieder aus Widerständen 45, Spulen 44 und Kondensatoren 43 verwendet werden und für jede der Subaperturen nach Wahl für die benötigten Frequenzen abgewandelt werden. Zur Erzeugung einer hohen Bandbreite eignen sich beispielsweise Schallwandler auf PVDF-Membran-Basis. Ebenso können die Subaperturen aber auch aus anderen Elementen gebildet werden. Bei der Verwendung mikrosystemtechnischer Schallwandler (cMUT, pMUT) für die einzelnen Subaperturen können beispielsweise die Schallwandler mit den zugehörigen elektronischen Filtern direkt auf einem Siliziumwafer integriert werden. In der Figur ist eine Reihe von Schallwandlern nebeneinander gezeigt, diese könnten aber auch in beliebiger Anordnung vorgesehen sein, beispielsweise kreisförmig oder als Gitter mit mehreren Spalten und Zeilen. Alle gefilterten Schallwandler 40a, 40b, 40c, ..., 40n bilden dann wiederum die Gesamtapertur mit einem überlagerten Frequenzspektrum aus allen Subaperturen.

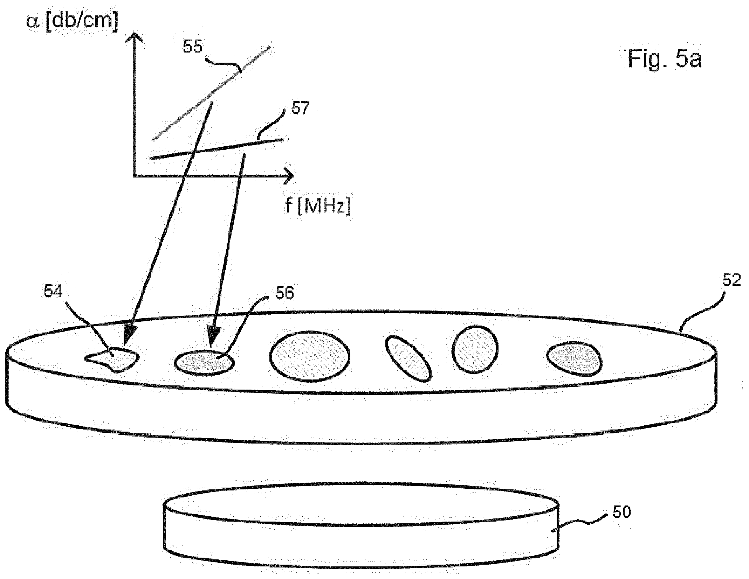

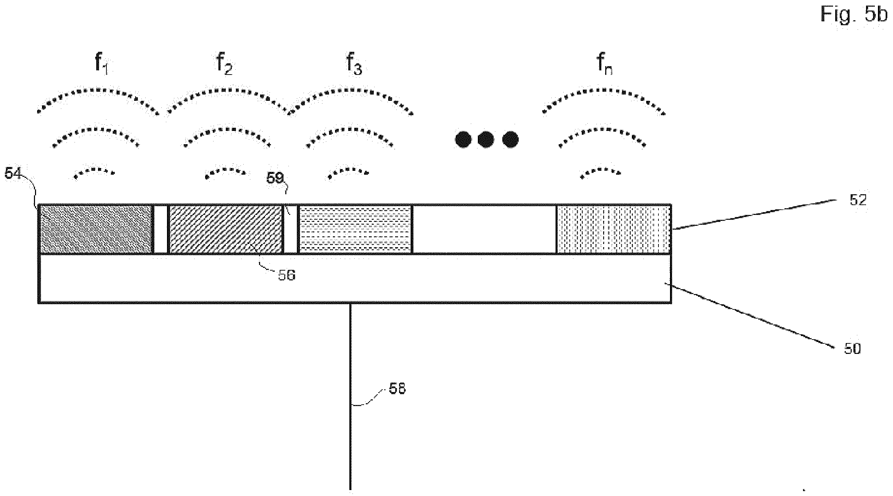

Eine weitere Ausführungsform nutzt ein passives Zusatzmodul für einen Schallwandler. Dieses ist als Beispiel in der Figur 5a dargestellt. Dabei wird einer einzelnen Apertur (d.h. einem einzelnen Schallwandler) 50 mit bevorzugt hoher Bandbreite ein passives Vorsatzmodul 52 vorgeschaltet, das den erzeugten Schall zumindest teilweise transmittiert und zu räumlich veränderlichen spezifischen Frequenzen und/oder Bandbreiten führt. Der Schallwandler ist erneut mit nur einem Ansteuerungskanal 58 verbunden. Dies kann beispielsweise realisiert werden, indem das passive Vorsatzmodul 52 ortsabhängig (wieder verteilt über die Aperturebene bzw. im Wesentlichen parallel dazu) mit Bereichen 54, 56 unterschiedlicher frequenzabhängiger Dämpfung versehen wird. Figur 5b zeigt eine zusammengesetzte Gesamtapertur gemäß Figur 5a im Querschnitt, wobei der Schallwandler 50 fest oder wechselbar mit dem Vorsatzmodul 52 verbunden sein kann. Der vom Schallwandler 50 erzeugte Schall wird also nach dem Verlassen der Apertur durch diese unterschiedlichen Bereiche 54, 56 transmittiert, so dass sich hinter dem Vorsatzmodul entsprechend der Verteilung der Dämpfungseigenschaften unterschiedliche Subaperturen mit unterschiedlichen spezifischen Frequenzen und Bandbreiten $f_1$, $f_2$, $f_3$, ....$f_n$ ausbilden. Die Figur 5a zeigt beispielhaft für zwei der dämpfenden Bereiche bzw. der Subaperturen auch entsprechende schematische Dämpfungskurven 55, 57 bzw. den Schallabsorptionsgrad $\alpha$ in db/cm gegen die Schallfrequenz aufgetragen. Während hier lineare Dämpfungskurven gezeigt sind, können je nach Material auch andere frequenzabhängige Verläufe auftreten und genutzt werden. In dem gezeigten Beispiel weist der Bereich 54 eine über alle Frequenzen, aber insbesondere für hohe Frequenzen stärkere Dämpfung 55 auf als der Bereich 56 mit der Dämpfungskurve 57.

Wahlweise kann ein passives Vorsatzmodul 52 durchgehend über seine gesamte Aperturfläche hinweg zumindest teilweise transmittieren oder so ausgebildet sein, dass sich auf der vom Schallwandler 50 abgewandten Seite (d.h. dem abstrahlenden Bereich der Apertur) auch Bereiche 59 zwischen den einzelnen Subaperturen bilden, von denen kein Schall ausgeht Derartige passive Module 52 können einfach hergestellt und abgeändert werden, so dass mit einem üblichen breitbandigen Schallwandler 50 und beispielsweise wechselbaren Vorsatzmodulen 52 eine Vielzahl unterschiedlich strukturierter Schallfelder erzeugt werden kann. Je nach verwendetem Material können passive Vorsatzmodule auf besonders einfache und kostengünstige Art und Weise gefertigt und spezifisch auf Anwendungsfälle angepasst werden. Erneut können auch andere als die gezeigten Grundformen verwendet werden, angelehnt beispielsweise an die Ausformungen, die bereits in Figur 2 schematisch gezeigt wurden.

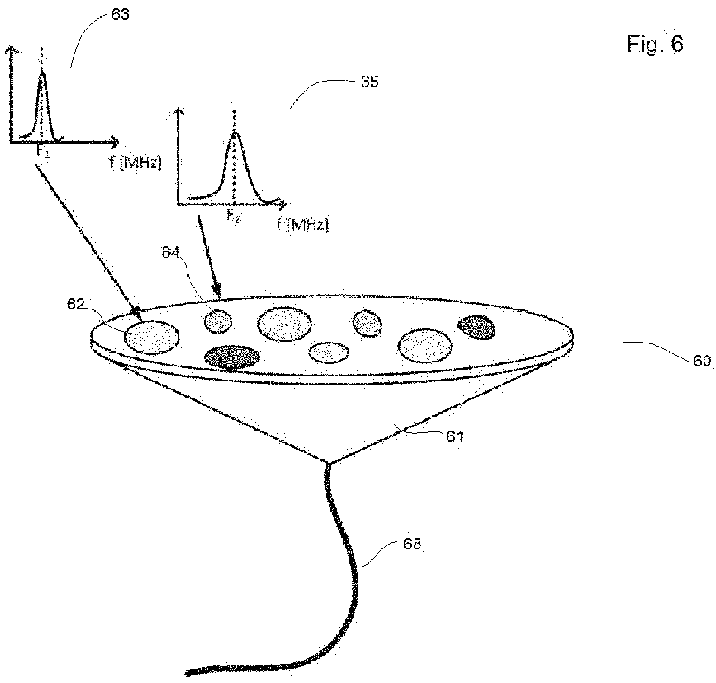

Neben der Schallerzeugung durch piezoelektrische oder kapazitive Wandler aller unterschiedlichen Bauformen kommen auch andere Möglichkeiten der UltraschallErzeugung für die vorliegende Erfindung in Betracht, beispielsweise die Erzeugung von photoakustischen Schallwellen durch gepulsten Laserstrahl, wie in Figur 6 gezeigt. Die Absorption der Energie des Laserstrahls 61 auf einem absorbierenden Material sorgt kurzzeitig für eine lokale Erwärmung und Ausdehnung, so dass bei wiederholten Pulsen mit entsprechender Länge und Frequenz (z.B. im Bereich von Nanosekunden), mit denen eine Membran 60 oder ein anderes geeignetes Element bestrahlt wird, Schwingungen der Membran und damit entsprechende Ultraschallfelder entstehen. Wenn eine derartige Membran 60 wie in Figur 6 gezeigt mit lokalen Bereichen 62, 64 unterschiedlicher Dicke und/oder Absorption ausgebildet und dann mit gepulstem Laserlicht 61 mit geeigneter Pulsfrequenz beleuchtet wird, können Ultraschallsignale erzeugt werden, die wieder räumlich und spektral kodiert sind. Die Membranbereiche 62, 64 mit unterschiedlichen Parametern bilden dabei die Subaperturen wie bereits in den vorherigen Beispielen. Beispielhaft sind zwei der entstehenden Frequenzkurven 63, 65 für die Bereiche 62, 64 in der Figur gezeigt. Ebenso können wieder die Bereiche unterschiedlicher Absorption bzw. unterschiedlicher Schwingungseigenschaften direkt ineinander übergehen oder durch andere Bereiche voneinander abgetrennt sein, so dass auf der Membran 60 z.B. Abschnitte vorgesehen sein können, die nicht oder kaum in den entsprechenden Wellenlängenbereichen absorbieren.

Dem einen Kanal zur Anregung bzw. Ansteuerung des Schallwandlers entspricht dabei die Einstrahlung von Laserpulsen 61 mit vorgegebener Frequenz und Pulsdauer sowie vorbestimmter Wellenlänge durch z.B. eine Laserfaser 68 auf die Gesamtapertur. Auch ein durchstimmbarer Laser, der eine Veränderung der Wellenlänge in einem gewissen Bereich erlaubt, könnte zur Anregung genutzt werden. Erneut ist die runde Grundform nur als beispielhafte Ausführungsform gezeigt und kann durch andere Formen ersetzt werden.

Grundsätzlich sind auch alle weiteren Schallerzeugungsverfahren für Ausführungsformen der Erfindung einsetzbar, solange es damit aktiv oder passiv möglich ist, eine räumliche Variation der emittierten Ultraschallfrequenzen zu erreichen. Beispielsweise sind auch Methoden denkbar, bei denen das Ultraschallsignal durch mechanische, elektromagnetische, elektrodynamische (induktive), elektrostriktive oder andere Verfahren erzeugt wird.

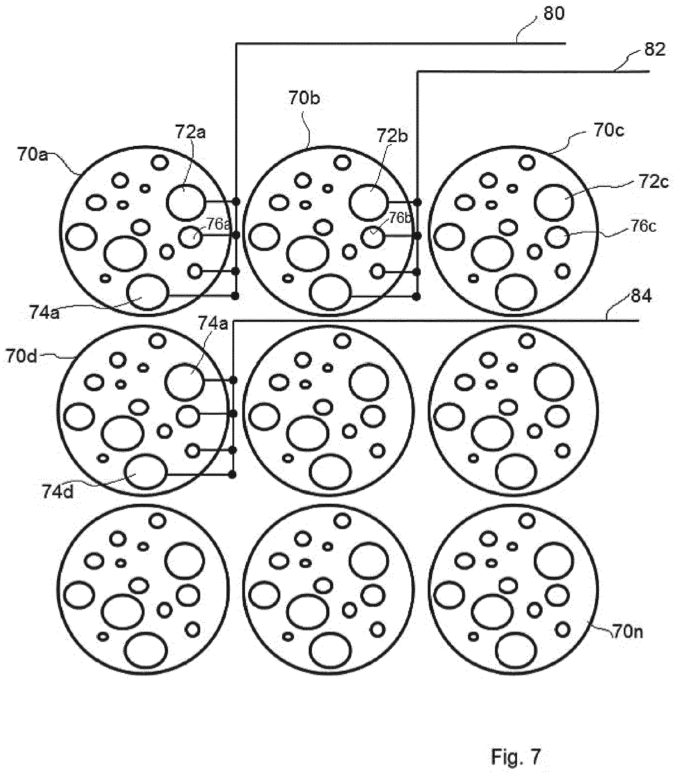

Wie in Figur 7 gezeigt ist, können auch mehrere frequenzkodierte Schallwandler 70a, 70b, 70c, 70d, ... 70n mit Subaperturen 72a/b/c, 74a/b/c, 76a/b/c wie zuvor beschrieben in einer weiteren Ausführungsform wiederum zu einem Array verbunden werden. Auf diese Weise kann bereits mit deutlich weniger Arrayelementen und insbesondere verringertem technischem und elektronischem Aufwand als üblich ein deutlich erweitertes Sichtfeld bzw. ein größerer Arbeitsbereich abgedeckt werden. Viele einzelne Arbeitsvolumen werden bei bekannter Position der Einzelwandler zu einem großen Gesamtvolumen zusammengefügt. Dabei kann wie in einem herkömmlichen Array auch jeder der erfindungsgemäßen Schallwandler 70a, 70b, 70c einzeln über die Kanäle 80, 82, 84 angesteuert werden, während die Subaperturen 72, 74, 76 der Schallwandler für jede spezifische Gesamtapertur jeweils gemeinsam über diese Kanäle angesteuert werden. Dabei sind in der Figur aus Gründen der Übersichtlichkeit nur einzelne Subaperturen und Aperturen beispielhaft mit Kontaktierungen bzw. elektrischen Kanälen gezeigt, während üblicherweise natürlich alle zugehörigen Subaperturen jeweils mit dem Ansteuerungskanal des jeweiligen Schallwandlers verbunden werden und jeder Schallwandler im Array seinen eigenen Ansteuerungskanal aufweist, auch wenn er in dieser Figur nicht dargestellt ist. Diese Ausführungsform kann mit beliebigen der vorherigen Ausführungsformen kombiniert werden; beispielsweise könnte ein Array aus mikrosystemtechnischen Wandlern wie in den Beispielen zu den Figuren 1 und 2 gebildet werden; ebenso könnte aber auch ein Array gebildet werden, indem in einem einzigen passiven Grundkörper mit einer Vielzahl von Einzelschallwandlern beispielsweise vier definierte Gruppen von Schallwandlern gebildet werden, bevorzugt nach ihrer räumlichen Anordnung, und für jede Gruppe ein elektrischer Ansteuerungskanal vorgesehen, so dass jede Gruppe von Einzelschallwandlern bzw. Subaperturen zusammen je eine Gesamtapertur bildet.

Alle oben beschriebenen Schallwandler und ihre Variationen können als Schallerzeuger und/oder Schallempfänger verwendet werden. Bei bildgebenden Verfahren und anderen Detektionsverfahren kann bevorzugt auch derselbe Wandler gleichzeitig als Sender und Empfänger eingesetzt werden; grundsätzlich können dafür aber auch zwei getrennte Schallwandler verwendet werden, solange das vom erzeugenden Schallwandler emittierte Schallfeld bekannt ist und damit zur Interpretation der reflektierten und gestreuten Signale verwendet werden kann.

Um aus den empfangenen Signalen eines derartigen Schallwandlers mit räumlich frequenzkodiertem Schallfeld eine räumlich eindeutige Zuordnung zu erreichen, können verschiedene Berechnungsverfahren angewendet werden.

Im Wesentlichen kann dabei berücksichtigt werden, dass ein räumlich-frequenzkodiertes Schallfeld einer emittierenden Gesamtapertur aus einer Überlagerung der Schallfelder der verschiedenen Subaperturen besteht, wobei jede der Subaperturen ein spezifisches Frequenzspektrum und eine zugehörige Amplitude aufweist Das resultierende Schallfeld kann durch eine Funktion

$h(x,y,z,t)$ beschrieben werden, wobei t die Zeit darstellt und $x$, $y$, $z$ die Raumkoordinaten am Punkt $(x,y,z)$ wiedergeben. Die Funktion h beschreibt dann den zeitlichen Druckverlauf des Reflexionssignals für einen Reflektor am Punkt $(x,y,z)$, also z.B. ein aus einem Gewebe oder Materialstück reflektiertes Signal. Die Funktion h kann in einer Matrixdarstellung gespeichert sein, wobei jeder Spaltenindex für einen Punkt im Raum $r = (x,y,z)$ und jeder Zeilenindex für einen Zeitpunkt steht. Wenn die Verteilung des Reflektors im Volumen dann durch $b(x,y,z)$ ( $\mathbb{R}^3 \to \mathbb{R}$ ) beschrieben wird, kann das resultierende Signal $\mathcal{S}$ für eine Kombination der durch $b$ beschriebenen Reflektoren durch $\mathcal{S} = h \times b$ erhalten werden. Wenn also ein Signal $\mathcal{S}$ durch einen Schallwandler erfasst wird und das Schallfeld h der emittierenden Apertur bekannt ist, kann die Verteilung der Reflektoren durch Umkehrung von $\mathcal{S} = h \times b$ bestimmt werden.

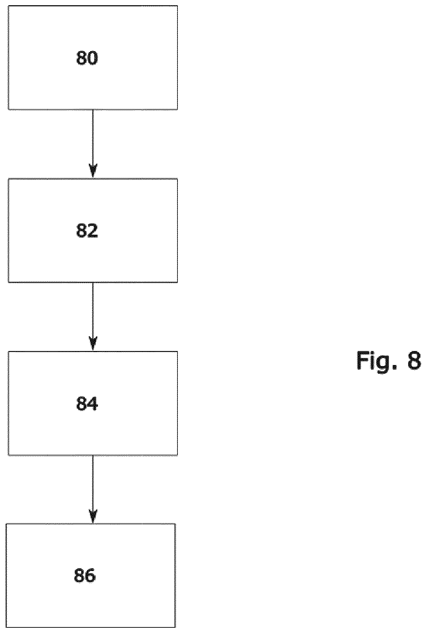

Eine dreidimensionale Signalerfassung ist auf diese Weise in den verschiedensten Anwendungsgebieten möglich. Figur 8 zeigt schematisch beispielhafte Verfahrensschritte für ein Detektionsverfahren unter Verwendung eines frequenzcodierten Schallwandlers. Dabei wird zunächst in Schritt 80 ein frequenzcodiertes Schallfeld mit bekannter räumlicher Verteilung h erzeugt und trifft auf ein interessierendes Objekt, wo der Schall zumindest teilweise reflektiert wird. In Schritt 82 wird das reflektierte Ultraschallsignal $\mathcal{S}$ durch einen Schallwandler wie zuvor beschrieben erfasst und als einzelnes Signal an eine Verarbeitungseinheit, z.B. einen geeigneten Prozessor weiter gegeben. Dort wird es in Schritt 84 durch geeignete Algorithmen oder Berechnungen unter Verwendung der Informationen über das eingestrahlte Schallfeld h rekonstruiert und damit die räumliche Verteilung der Reflektoren b erhalten. Schließlich kann in Schritt 86 dieses Ergebnis weiterverarbeitet werden und beispielsweise in Form von Bilddaten wiedergegeben werden.

Ebenso sind Schallwandler gemäß beispielhaften Ausführungsformen für Anwendungen einsetzbar, in denen keine Bildgebung erforderlich ist, sondern ein anwendungsspezifisches Schallfeldmuster erzeugt werden soll, beispielsweise eine definierte Fokusposition oder auch komplexere Schallfelder. Dies gilt beispielsweise für die Ultraschalltherapie, bei der ein Fokus an einer bestimmten Stelle im Gewebe positioniert werden soll. Somit können spezifische Ultraschallfelder z.B. für Fertigungsprozesse gebildet werden, etwa für den ultraschallinduzierten Phasen-Transfer zur lokalen Verfestigung von Materialien.

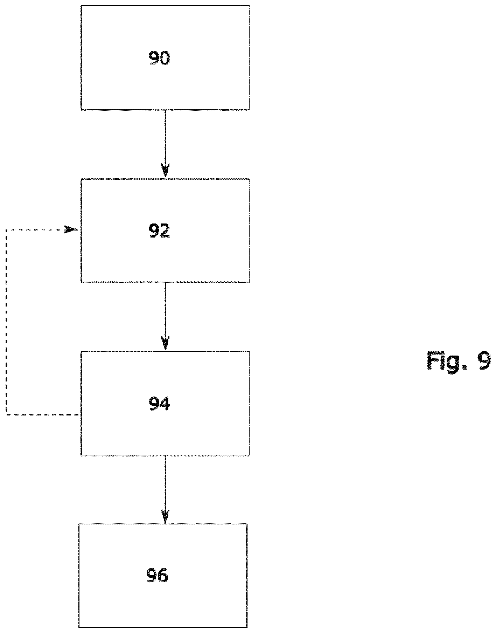

Zu diesem Zweck können verschiedene analytische Berechnungen, numerische Ansätze, Simulationen und ähnliche Verfahren angewendet werden, die für eine vorgegebene Ausführungsform die notwendigen Fertigungsparameter berechnen, um daraus ein gewünschtes Schallfeld F zu bilden. Figur 9 zeigt beispielhafte Schritte eines Verfahrens zum Entwerfen eines Schallwandlers. Die Art der Frequenzcodierung ist dabei anwendungsspezifisch. Dabei wird in Schritt 90 eine gewünschte Schallfeldverteilung ($F(x,y,z)$, $\mathrm{F}: \mathbb{R}^3 \to \mathbb{R}$ ) festgelegt bzw. ausgewählt und dann in Schritt 92 durch geeignete Verfahren ein Set von räumlich verteilten Teil-Schallfeldern gesucht bzw. berechnet, welches bei Überlagerung aller Teil-Schallfelder die gewünschte Schallfeldverteilung F ergibt Dann können in einem nächsten Schritt 94 geeignete Subaperturen gewählt werden, welche in der Lage sind, die erforderlichen Teil-Schallfelder zu erzeugen. Die Auslegung der Subaperturen ist dabei auch abhängig von der Wahl der Ausführungsform. Alternativ kann die Simulation bzw. Berechnung direkt die geeigneten Subaperturen optimieren, bis das überlagerte Schallfeld der gewünschten räumlichen Strukturierung entspricht, beispielsweise ausgehend von einer symmetrischen bzw. homogen verteilten Anfangskonfiguration oder von identischen Subaperturen, die dann entsprechend der erwünschten Fokuslage und Raumstruktur des Schallfelds abgeändert werden. Wie in der Figur angedeutet, können die Schritte 92 und 94 optional auch wiederholt bzw. mehrfach durchlaufen werden, um beispielsweise ein Design in mehreren Schritten weiter zu optimieren. Schließlich können die gefundenen Parameter in Schritt 96 weiter verarbeitet, an eine Bearbeitungseinheit übertragen, abgespeichert oder auf andere Weise genutzt werden.

In bestimmten Fällen kann auch eine randomisierte Frequenzcodierung und damit eine randomisierte Ausbildung und Anordnung der Subaperturen gewählt werden. Beispielsweise ist bei der Verwendung von Bildgebung auf Basis von Compressed Sensing eine derartige randomisierte oder pseudorandomisierte Frequenzcodierung möglich.

In entsprechende Simulationsverfahren können dabei optional auch Fertigungsparameter wie z.B. Materialkosten oder Randbedingungen wie maximale Abmessungen einer Apertur einfließen, um die optimale Verteilung und Auslegung der Subaperturen für ein gewünschtes Gesamt-Schallfeld unter Berücksichtigung solcher Aspekte zu finden.

Ein beispielhaftes Verfahren zur Herstellung solcher räumlich frequenzcodierter Schallwandler kann beispielsweise in Form von geeigneter Software und/oder Hardware implementiert sein, in der ein entsprechendes Simulations- oder Berechnungsverfahren umgesetzt ist Die Ergebnisse können dann z.B. unmittelbar in ein Fertigungsverfahren für einen Ultraschallwandler einfließen. Je nach Fertigungsweise können die durch Berechnung oder Simulation gefundenen Parameter direkt an ein Bearbeitungszentrum oder andere Fertigungssysteme weitergeleitet werden und dort umgesetzt werden. Alternativ können die Ergebnisse auf geeignete Weise abgespeichert, angezeigt und/oder übertragen werden.

Ganz allgemein sind die beschriebenen Schallwandler mit frequenzcodiertem Schallfeld in den verschiedensten technischen Gebieten einsetzbar. Dazu zählen beispielsweise Sensoren für volumetrische Abstands-, Füllstands- und Durchflussmessungen, etwa im Kraftfahrzeugbereich; Ultraschall für medizinische Diagnostik und Therapie, z.B. auch fokussierter Ultraschall zur medizinischen Therapie oder Stimulation (high intensity focused ultrasound, HIFU); dreidimensionale Bildgebung in medizinischen und nichtmedizinischen Anwendungen; zerstörungsfreie Materialprüfung, z.B. in Fertigungsabläufen und zu Testzwecken; dreidimensionale Zustandsüberwachung von Systemen; Oberflächenerfassung in den verschiedensten Bereichen, z.B. Luft, Wasser, Gewebe, Feststoffe; Sonar-Systeme; ultraschallgestützte Materialbearbeitung und dreidimensionale Materialstrukturierung; 3D-Druckverfahren; dreidimensionale Manipulation z.B. von Partikeln oder Zellen; Abstandsmessungen, wie z.B. Sensoren in Stoßstangen von Kraftfahrzeugen, und viele weitere. In vielen dieser Anwendungen können die beschriebenen Sensoren bzw. Schallwandler dafür sorgen, dass eine wesentlich geringere Anzahl von Sensoren erforderlich ist, beispielsweise nur noch ein einziger Sensor in einer Stoßstange statt drei bis fünf der üblichen Sensoren, während gleichzeitig eine dreidimensionale Messung ohne erweiterten Signalaufwand möglich wird. Die geringen Datenmengen aufgrund der einkanaligen Übertragung bieten große Vorteile für Übertragungen über Funkschnittstellen und in anderen Bereichen. Insgesamt sorgen sowohl die geringe Baugröße als auch die deutliche Verringerung der elektronischen Kontaktierungen und Signalkanäle für eine wesentliche Reduzierung der Kosten.

Je nach Bereich können die Schallwandler dabei nur zur Erzeugung von Ultraschall, nur zur Erfassung von Ultraschall, oder kombiniert zum Erzeugen und Erfassen von Ultraschallfeldern dienen, wie es beispielsweise für die Bildgebung erforderlich ist. Dabei können wahlweise auch mehrere Schallwandler eingesetzt werden, z.B. ein kombiniertes Element aus zwei Wandlerelementen, von denen eines zum Empfang und eines zum Erzeugen eines Schallfelds vorgesehen ist.

Generell sind die erfindungsgemäßen Schallwandler beispielsweise durch die Einsparung an Bauraum und Kosten durch die Ansteuerung durch nur einen elektronischen Ansteuerungs-/Empfangskanal für die gesamte Apertur und den hohen möglichen Integrationsgrad (z.B. bei integrierter Fertigung mit anderen Komponenten auf einem Wafer oder einer Leiterplatte) besonders gut in digitalisierten industriellen Anwendungen einsetzbar (sogenannte Industrie 4.0). Die Rekonstruktion eines durch einen derartigen Wandler erfassten Schallfelds ist mit vergleichsweise geringem Rechenaufwand möglich, während die Komplexität der elektrischen bzw. elektronischen Elemente deutlich reduziert wird.

**Patentansprüche**

1.  Vorrichtung zum Erfassen einer dreidimensionalen Struktur durch ein Ultraschallsignal, umfassend:

    einen frequenzcodierten Schallwandler zum Empfangen und/oder Erzeugen eines räumlich strukturierten Schallfelds, wobei der frequenzcodierte Schallwandler eine Gesamtapertur(10, 20, 30, 52, 60, 70) umfasst, wobei die Gesamtapertur mehrere Subaperturen (12, 14, 16, 18; 22, 24, 26, 28; 36a, 36b; 40a, 40b, 40n; 54, 56; 62, 64) umfasst,
    wobei jede der Subaperturen zum Empfangen und/oder Erzeugen von Schallfeldern mit einem spezifischen Frequenzspektrum eingerichtet ist,
    wobei sich die spezifischen Frequenzspektren von mindestens zwei der Subaperturen unterscheiden, und
    wobei alle Subaperturen der Gesamtapertur mit demselben elektronischen Ansteuerungskanal (38, 39; 48; 58; 80, 82, 84) verbunden sind;
    eine Verarbeitungseinheit, welche dazu eingerichtet ist, ein durch den frequenzcodierten Schallwandler erfasstes Ultraschallsignal, welches an schallreflektierenden Elementen reflektierte und gestreute Signale eines durch den frequenzcodierten Schallwandler eingestrahlten Schallfelds umfasst, auf Basis eines bekannten spezifischen Schallfelds des frequenzcodierten Schallwandlers zu dekodieren, wobei das spezifische Schallfeld eine Überlagerung der Schallfelder der Subaperturen darstellt; und
    wobei die Verarbeitungseinheit weiter dazu eingerichtet ist, eine Verteilung der schallreflektierenden Elemente im dreidimensionalen Raum aus dem dekodierten Ultraschallsignal zu erhalten.

2.  Vorrichtung nach Anspruch 1, wobei die mehreren Subaperturen im Wesentlichen in einer Ebene senkrecht zur Ausbreitungsrichtung des Schallfelds verteilt angeordnet sind.

3.  Vorrichtung nach Anspruch 1 oder 2, wobei die mehreren Subaperturen zumindest teilweise unterschiedliche Durchmesser aufweisen.

4.  Vorrichtung nach einem der vorhergehenden Ansprüche, wobei der elektrische Ansteuerungskanal zum Ausgeben eines Wechselsignals mit einem vorgegebenen Frequenzspektrum an die Subaperturen eingerichtet ist, wobei das Wechselsignal zumindest ein bewegliches Element jeder Subapertur zu Schwingungen anregt.

5.  Vorrichtung nach einem der vorhergehenden Ansprüche, wobei die Gesamtapertur durch ein Piezoelement (30) gebildet wird, und wobei die Subaperturen durch Bereiche des Piezoelements mit unterschiedlicher Dicke (36a, 36b) gebildet werden.

6.  Vorrichtung nach einem der Ansprüche 1 bis 4, wobei die Gesamtapertur als piezoelektrischer oder kapazitiver mikromechanischer Schallwandler ausgebildet ist und die mehreren Subaperturen als mehrere Membranen (12, 14, 16, 18; 22, 24, 26, 28) des frequenzcodierten Schallwandlers ausgebildet sind, und wobei die Membranen zumindest teilweise unterschiedliche Durchmesser aufweisen.

7.  Vorrichtung nach einem der Ansprüche 1 bis 4, wobei die Gesamtapertur aus einem frequenzcodierten Einzelschallwandler (50) mit hoher Bandbreite zusammen mit einem passiven Vorsatzmodul (52) für den Einzelschallwandler gebildet wird, wobei das passive Vorsatzmodul Bereiche (54, 56) unterschiedlicher frequenzabhängiger Dämpfung umfasst, welche die mehreren Subaperturen bilden.

8.  Vorrichtung nach einem der Ansprüche 1 bis 4, wobei die Subaperturen durch frequenzcodierten Einzelschallwandler (40a, 40b, 40c, ..., 40n) mit hoher Bandbreite gebildet werden, wobei jedem der frequenzcodierten Einzelschallwandler ein elektronischer Filter (42a, 42b, 42c, ..., 42n) vorgeschaltet ist, welcher die Bandbreite des frequenzcodierten Einzelschallwandlers auf ein spezifisches Frequenzspektrum beschränkt.

9.  Vorrichtung nach einem der Ansprüche 1 bis 4, wobei die Gesamtapertur durch einen passiven Grundkörper mit Ausnehmungen für mehrere frequenzcodierten Einzelschallwandler gebildet wird, wobei die mehreren frequenzcodierten Einzelschallwandler die mehreren Subaperturen bilden.

10. Vorrichtung nach einem der Ansprüche 1 bis 4, wobei die Gesamtapertur durch eine Membran (60) gebildet wird, und wobei die Subaperturen durch lokale Bereiche (62, 64) der Membran mit unterschiedlicher Dicke und/oder unterschiedlichen Absorptionseigenschaften ausgebildet sind, wobei der frequenzcodierte Schallwandler weiter eine Lichtquelle umfasst, die dazu eingerichtet ist, gepulstes Laserlicht auf die Membran einzustrahlen.

11. Verfahren zur Bildgebung mittels eines räumlich strukturierten Schallfelds, umfassend:

Erfassen (82) eines Ultraschallsignals ($S$), welches an schallreflektierenden Elementen reflektierte und gestreute Signale eines eingestrahlten Schallfelds (80) umfasst, wobei das eingestrahlte Schallfeld durch einen ersten frequenzcodierten Schallwandler erzeugt wurde, wobei der erste frequenzcodierte Schallwandler eine Gesamtapertur (10, 20, 30, 52, 60, 70) umfasst, welche das Schallfeld erzeugt, wobei die Gesamtapertur mehrere Subaperturen (12, 14, 16, 18; 22, 24, 26, 28; 36a, 36b; 40a, 40b, 40n; 54, 56; 62, 64) umfasst, wobei jede der Subaperturen zum Erzeugen von Schallfeldern mit einem spezifischen Frequenzspektrum eingerichtet ist, wobei sich die spezifischen Frequenzspektren von mindestens zwei der Subaperturen unterscheiden, und wobei alle Subaperturen der Gesamtapertur mit demselben elektronischen Ansteuerungskanal (38, 39; 48; 58; 80, 82, 84) verbunden sind, wobei das erfasste Ultraschallsignal als Ausgangssignal des elektronischen Ansteuerungskanals vorliegt; Dekodieren des erfassten Ultraschallsignals ($S$) unter Verwendung des bekannten spezifischen Schallfelds des ersten frequenzcodierten Schallwandlers, mit dem das eingestrahlte Schallfeld erzeugt wurde, wobei das spezifische Schallfeld eine Überlagerung der Schallfelder der Subaperturen darstellt; und Erhalten (84), aus dem dekodierten Ultraschallsignal, einer räumlichen Verteilung der schallreflektierenden Elemente.

12. Verfahren nach Anspruch 11, weiter umfassend: Darstellen (86) eines zweidimensionalen oder dreidimensionalen Bilds aus der erhaltenen räumlichen Verteilung von reflektierenden Elementen.

13. Verfahren nach Anspruch 11 oder 12, wobei das Ultraschallsignal mit einem zweiten frequenzcodierten Schallwandler erfasst wird, welcher eine Gesamtapertur (10, 20, 30, 52, 60, 70) umfasst, welche das Schallfeld empfängt, wobei die Gesamtapertur mehrere Subaperturen (12, 14, 16, 18; 22, 24, 26, 28; 36a, 36b; 40a, 40b, 40n; 54, 56; 62, 64) umfasst, wobei jede der Subaperturen zum Empfangen von Schallfeldern mit einem spezifischen Frequenzspektrum eingerichtet ist, wobei sich die spezifischen Frequenzspektren von mindestens zwei der Subaperturen unterscheiden, und wobei alle Subaperturen der Gesamtapertur mit demselben elektronischen Kanal (38, 39; 48; 58; 80, 82, 84) verbunden sind;

**14.** Verfahren nach Anspruch 13, wobei der erste frequenzcodierte Schallwandler und der zweite frequenzcodierte Schallwandler durch denselben frequenzcodierten Schallwandler gebildet sind.

**Claims**

**1.** A device for detecting a three-dimensional structure by an ultrasonic signal, comprising:

a frequency-encoded sound transducer for receiving and/or generating a spatially structured sound field, wherein the frequency-encoded sound transducer comprises a total aperture (10, 20, 30, 52, 60, 70), wherein the total aperture comprises a plurality of subapertures (12, 14, 16, 18; 22, 24, 26, 28; 36a, 36b; 40a, 40b, 40n; 54, 56; 62, 64),
each of the sub-apertures being setup to receive and/or generate sound fields with a specific frequency spectrum,
wherein the specific frequency spectra of at least two of the subapertures differ, and
whereby all sub-apertures of the overall aperture are connected to the same electronic control channel (38, 39; 48; 58; 80, 82, 84);
a processing unit arranged to decode an ultrasonic signal detected by the frequency-encoded transducer, which comprises signals reflected and scattered at sound-reflecting elements of a sound field irradiated by the frequency-encoded transducer, on the basis of a known specific sound field of the frequency-encoded transducer, the specific sound field representing a superposition of the sound fields of the sub-apertures; and
wherein the processing unit is further arranged to obtain a distribution of the sound-reflecting elements in three-dimensional space from the decoded ultrasonic signal.

**2.** Device according to claim 1, wherein the plurality of subapertures are distributed substantially in a plane perpendicular to the direction of propagation of the sound field.

**3.** Device according to claim 1 or 2, wherein the plurality of subapertures have, at least in part, different diameters.

**4.** Device according to one of the preceding claims, wherein the electrical control channel is arranged to output an alternating signal with a predetermined frequency spectrum to the subapertures, wherein the alternating signal excites at least one movable element of each subaperture to vibrate.

**5.** Device according to any one of the preceding claims, wherein the overall aperture is formed by a piezo element (30), and wherein the subapertures are formed by regions of the piezo element having different thicknesses (36a, 36b).

**6.** Device according to any one of claims 1 to 4, wherein the overall aperture is formed as a piezoelectric or capacitive micromechanical transducer and the plurality of subapertures are formed as a plurality of diaphragms (12, 14, 16, 18; 22, 24, 26, 28) of the frequency-coded transducer, and wherein the diaphragms have at least partially different diameters.

**7.** Device according to any one of claims 1 to 4, wherein the overall aperture is formed by a frequency-coded single sound transducer (50) with high bandwidth together with a passive attachment module (52) for the single sound transducer, wherein the passive attachment module comprises regions (54, 56) of different frequency-dependent attenuation forming the plurality of sub-apertures.

**8.** Device according to one of claims 1 to 4, wherein the subapertures are formed by frequency-coded individual sound transducers (40a, 40b, 40c, ..., 40n) with a high bandwidth, wherein an electronic filter (42a, 42b, 42c, ..., 42n) is connected upstream of each of the frequency-coded individual sound transducers, which filter limits the bandwidth of the frequency-coded individual sound transducer to a specific frequency spectrum.

**9.** Device according to any one of claims 1 to 4, wherein the overall aperture is formed by a passive base body having recesses for a plurality of frequency-coded individual sound transducers, wherein the plurality of frequency-coded individual sound transducers form the plurality of subapertures.

**10.** Device according to any one of claims 1 to 4, wherein the overall aperture is formed by a membrane (60), and wherein the subapertures are formed by local regions (62, 64) of the membrane having different thickness and/or different absorption properties, wherein the frequency-encoded transducer further comprises a light source arranged to irradiate pulsed laser light onto the membrane.

**11.** Method for imaging by means of a spatially structured sound field, comprising:

detecting (82) an ultrasonic signal ($S$) comprising reflected and scattered signals of an irradiated sound field (80) at sound reflecting elements, wherein the irradiated sound field is generated by a first frequency-coded sound transducer,

wherein the first frequency-encoded sound transducer comprises an overall aperture (10, 20, 30, 52, 60, 70) generating the sound field, the overall aperture comprising a plurality of sub-apertures (12, 14, 16, 18; 22, 24, 26, 28; 36a, 36b; 40a, 40b, 40n; 54, 56; 62, 64), wherein each of the sub-apertures is arranged to generate sound fields with a specific frequency spectrum, wherein the specific frequency spectra of at least two of the sub-apertures differ, and wherein all sub-apertures of the overall aperture are connected to the same electronic control channel (38, 39; 48; 58; 80, 82, 84), wherein the detected ultrasonic signal is present as an output signal of the electronic control channel; decoding the detected ultrasonic signal ($S$) using the known specific sound field of the first frequency-encoded transducer with which the radiated sound field was generated, wherein the specific sound field represents a superposition of the sound fields of the subapertures; and

obtaining (84), from the decoded ultrasonic signal, a spatial distribution of the sound reflecting elements.

12. The method of claim 11, further comprising:
Representing (86) a two-dimensional or three-dimensional image from the obtained spatial distribution of reflective elements.

13. The method according to claim 11 or 12, wherein the ultrasonic signal is detected with a second frequency-encoded transducer comprising a total aperture (10, 20, 30, 52, 60, 70) receiving the sound field, the total aperture comprising a plurality of sub-apertures (12, 14, 16, 18; 22, 24, 26, 28; 36a, 36b; 40a, 40b, 40n; 54, 56; 62, 64), each of the sub-apertures being arranged to receive sound fields having a specific frequency spectrum,
wherein the specific frequency spectra of at least two of the sub-apertures differ, and wherein all sub-apertures of the overall aperture are connected to the same electronic channel (38, 39; 48; 58; 80, 82, 84);

14. The method according to claim 13, wherein the first frequency-encoded transducer and the second frequency-encoded transducer are formed by the same frequency-encoded transducer.

**Revendications**

1. Dispositif de détection d'une structure tridimensionnelle par un signal ultrasonore, comprenant :

un transducteur acoustique codé en fréquence pour recevoir et/ou générer un champ acoustique structuré spatialement, le transducteur acoustique codé en fréquence comprenant une ouverture totale (10, 20, 30, 52, 60, 70), l'ouverture totale comprenant plusieurs sous-ouvertures (12, 14, 16, 18 ; 22, 24, 26, 28 ; 36a, 36b ; 40a, 40b, 40n ; 54, 56 ; 62, 64),
chacune des sous-ouvertures étant agencée pour recevoir et/ou générer des champs sonores ayant un spectre de fréquences spécifique, les spectres de fréquence spécifiques d'au moins deux des sous-ouvertures étant différents, et
dans lequel toutes les sous-ouvertures de l'ouverture totale sont connectées au même canal de commande électronique (38, 39 ; 48 ; 58 ; 80, 82, 84) ;
une unité de traitement adaptée pour décoder un signal ultrasonore détecté par le transducteur acoustique à codage de fréquence, qui comprend des signaux réfléchis et diffusés par des éléments réfléchissant le son d'un champ sonore irradié par le transducteur acoustique à codage de fréquence, sur la base d'un champ sonore spécifique connu du transducteur acoustique à codage de fréquence, le champ sonore spécifique représentant une superposition des champs sonores des sous-ouvertures ; et
dans lequel l'unité de traitement est en outre agencée pour obtenir une répartition des éléments réfléchissant le son dans l'espace tridimensionnel à partir du signal ultrasonore décodé.

2. Dispositif selon la revendication 1, dans lequel les multiples sous-ouvertures sont réparties sensiblement dans un plan perpendiculaire à la direction de propagation du champ acoustique.

3. Dispositif selon la revendication 1 ou 2, dans lequel les multiples sous-ouvertures présentent au moins partiellement des diamètres différents.

4. Dispositif selon l'une quelconque des revendications précédentes, dans lequel le canal de commande électronique est agencé pour délivrer aux sous-ouvertures un signal alternatif ayant un spectre de fréquences prédéterminé, le signal alternatif faisant vibrer au moins un élément mobile de chaque sous-ouverture.

5. Dispositif selon l'une quelconque des revendications précédentes, dans lequel l'ouverture totale est formée par un élément piézoélectrique (30), et dans lequel les sous-ouvertures sont formées par des zones de l'élément piézoélectrique d'épaisseur différente (36a, 36b).

6. Dispositif selon l'une des revendications 1 à 4, dans lequel l'ouverture totale est réalisée sous la forme d'un transducteur acoustique micromécanique piézoélectrique ou capacitif et les multiples sous-ouvertures sont réalisées sous la forme de plusieurs membranes (12, 14, 16, 18 ; 22, 24, 26, 28) du transducteur acoustique codé en fréquence, et dans lequel les membranes présentent au moins partiellement des diamètres différents.

7. Dispositif selon l'une des revendications 1 à 4, dans lequel l'ouverture totale est formée d'un transducteur acoustique unique (50) à codage fréquentiel et à largeur de bande élevée, conjointement avec un module additionnel passif (52) pour le transducteur acoustique unique, le module additionnel passif comprenant des zones (54, 56) d'atténuation différente en fonction de la fréquence, qui forment les multiples sous-ouvertures.

8. Dispositif selon l'une des revendications 1 à 4, dans lequel les sous-ouvertures sont formées par des transducteurs acoustiques individuels codés en fréquence (40a, 40b, 40c, ..., 40n) à bande passante élevée, chacun des transducteurs acoustiques individuels codés en fréquence étant précédé d'un filtre électronique (42a, 42b, 42c, ..., 42n) qui limite la bande passante du transducteur acoustique individuel codé en fréquence à un spectre de fréquences spécifique.

9. Dispositif selon l'une des revendications 1 à 4, dans lequel l'ouverture totale est formée par un corps de base passif comportant des évidements pour plusieurs transducteurs acoustiques individuels codés en fréquence, les plusieurs transducteurs acoustiques individuels codés en fréquence formant les plusieurs sous-ouvertures.

10. Dispositif selon l'une quelconque des revendications 1 à 4, dans lequel l'ouverture totale est formée par une membrane (60), et dans lequel les sous-ouvertures sont formées par des zones locales (62, 64) de la membrane ayant une épaisseur différente et/ou des propriétés d'absorption différentes, le transducteur acoustique codé en fréquence comprenant en outre une source de lumière adaptée pour irradier une lumière laser pulsée sur la membrane.

11. Procédé d'imagerie au moyen d'un champ sonore structuré spatialement, comprenant :

la détection (82) d'un signal ultrasonore (S) comprenant des signaux réfléchis et diffusés par des éléments réfléchissant le son d'un champ sonore rayonné (80), dans lequel le champ sonore rayonné a été généré par un premier transducteur sonore codé en fréquence, dans lequel le premier transducteur codé en fréquence comprend une ouverture totale (10, 20, 30, 52, 60, 70) qui génère le champ sonore, l'ouverture totale comprenant une pluralité de sous-ouvertures (12, 14, 16, 18 ; 22, 24, 26, 28 ; 36a, 36b ; 40a, 40b, 40n ; 54, 56 ; 62, 64), chacune des sous-ouvertures étant agencée pour générer des champs sonores ayant un spectre de fréquence spécifique, les spectres de fréquence spécifiques d'au moins deux des sous-ouvertures étant différents, et toutes les sous-ouvertures de l'ouverture totale étant reliées au même canal de commande électronique (38, 39 ; 48 ; 58 ; 80, 82, 84), le signal ultrasonore détecté étant présent en tant que signal de sortie du canal d'attaque électronique ; décoder le signal ultrasonore détecté ($S$) en utilisant le champ sonore spécifique connu du premier transducteur codé en fréquence avec lequel le champ sonore irradié a été généré, le champ sonore spécifique représentant une superposition des champs sonores des sous-ouvertures ; et
obtenir (84), à partir du signal ultrasonore décodé, une répartition spatiale des éléments réfléchissant le son.

12. Procédé selon la revendication 11, comprenant en outre
la représentation (86) d'une image bidimensionnelle ou tridimensionnelle à partir de la distribution spatiale obtenue d'éléments réfléchissants.

13. Procédé selon la revendication 11 ou 12, dans lequel le signal ultrasonore est détecté avec un second transducteur acoustique codé en fréquence comprenant une ouverture totale (10, 20, 30, 52, 60, 70) qui reçoit le champ acoustique, l'ouverture totale comprenant une pluralité de sous-ouvertures (12, 14, 16, 18 ; 22, 24, 26, 28 ; 36a, 36b ; 40a, 40b, 40n ; 54, 56 ; 62, 64), chacune des sous-ouvertures étant adaptée pour recevoir des champs acoustiques ayant un spectre de fréquences spécifique,
dans lequel les spectres de fréquence spécifiques d'au moins deux des sous-ouvertures diffèrent, et dans lequel toutes les sous-ouvertures de l'ouverture totale sont connectées au même canal électronique (38, 39 ; 48 ; 58 ; 80, 82, 84) ;

14. Procédé selon la revendication 13, dans lequel le premier transducteur sonore codé en fréquence et le deuxième transducteur sonore codé en fréquence sont formés par le même transducteur sonore codé en fréquence.

Fig. 1

Fig. 2c

Fig. 2b

Fig. 2a

Fig. 3b

Fig. 3a

Fig. 3c

EP 3 972 746 B1

Fig. 3d

EP 3 972 746 B1

Fig. 4

EP 3 972 746 B1

α [db/cm]

55

57

f [MHz]

54

56

52

50

Fig. 5a

EP 3 972 746 B1

Fig. 5b

Fig. 6

Fig. 7

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20170217794 A1
- US 5870351 A

**In der Beschreibung aufgeführte Nicht-Patentliteratur**

- **KRUIZINGA et al.** Comprehensive 3D Ultrasound imaging using a single sensor. *Science Advances,* 2017